# EUROPEAN PATENT APPLICATION

(11) **EP 2 698 971 A1**
(43) Date of publication of application: **19.02.2014**
(21) Application number: 13180604.4
(22) Date of filing: 15.08.2013
(51) Int. Cl.: H04M 1/215

(54) **Audio amplification apparatus**

(30) Priority: 15.08.2012 GB 201214573
(71) Applicant: Britton, Colin, Layham, Suffolk IP7 5JZ (GB)
(72) Inventor: Britton, Colin, Layham, Suffolk IP7 5JZ (GB)
(74) Representative: Laudens

(57) **Abstract**

An audio amplification apparatus for attachment to a device having a loudspeaker. The apparatus (10) comprises a vibration transducer (30) for attachment to the device having the loudspeaker (20), an amplifier (40) coupled to the vibration transducer (30) for amplifying an electrical signal representing at least in part an audible output of the loudspeaker (24), and an audio output port (52) operably coupled to the amplifier, thereby permitting connection to an audio output device (60).

## Description

This invention relates to an audio amplification apparatus for attachment to an audio device having a loudspeaker. The present invention further relates to a method of amplifying an audible output of a device having a loudspeaker.

This invention finds particular utility with personal navigation devices (PNDs), for example satellite navigation devices, or other devices having an audio output used in situations where there are high levels of ambient noise.

PNDs are widely deployed in vehicles to provide both visual and audible instructions to help a driver navigate to their destination. PNDs are therefore normally provided with a screen for the visual instructions, and a loudspeaker in order that the audible instructions can be heard. The audible sounds can be heard quite easily within a vehicle such as a car due to a minimal amount of ambient noise. As such, and also due to the legal requirements of certain countries, PNDs are typically not provided with an audio output port.

Ordinarily this does not present a problem, because generally a user will be able to hear the audible sounds clearly enough without the use of personal headphones or a headset that supports a personal area network; such headsets or headphones may instead be worn to enable the driver to use a mobile telephone.

There is more of a problem, however, in situations where there is significantly greater ambient noise, and as such it will be difficult or impossible to hear the audible sound coming from the PND. In these situations, headphones or a headset are required to hear the audible sound. One particular example where this situation may arise is when a PND that is intended for use in a car is used instead on a motorcycle. PNDs that are specific for motorcycles are generally provided with audio output ports, so they can be used either with headphones, be plugged into a motorcycle helmet speaker system, or can support personal area networks such as Bluetooth. However, specialist motorcycle PNDs are often more expensive than those adapted for use with a car or in a pedestrian environment, and furthermore, motorcyclists are often in possession of a car as well, and in such instances would prefer to use a single PND for both vehicles, rather than having to purchase one separately for each vehicle.

A car-specific PND lacking an audio output port is, however, unsuitable for use on a motorcycle, because the significant ambient noise means that a user will not be able to hear the audible sound from the loudspeaker therein. In fact, motorcycle riders often wear earplugs to overcome the excessive ambient noise. Because there is no audio output port, there is no way to attach headphones. Attempts have been made to overcome this problem, such as providing a hollow plastic tube, which is adhered to the loudspeaker of the PND at one end, and provided with an earpiece on the other. This low-tech solution is fraught with problems and still presents a problem because the sound quality is poor.

The present invention provides an amplification device which can be used in conjunction with an audio device to enable a user to better hear the audible sound from the device, and which overcomes the problem of significant ambient noise.

Therefore, according to the present invention, there is provided an audio amplification apparatus for attachment to a device having a loudspeaker, the apparatus comprising: a vibration transducer for attachment to the device having the loudspeaker; an amplifier coupled to the vibration transducer for amplifying an electrical signal produced by the vibration transducer representing at least in part an audible output of the loudspeaker of the device, the vibration transducer picking up vibrations caused by sound emitted from the loudspeaker; and an audio output port operably coupled to the amplifier, thereby permitting connection to an audio output device.

The vibration transducer may be a piezoelectric microphone. It has been found that a piezoelectric microphone is by far the most suitable type of microphone for use with the present invention, because alternative microphones such as dynamic microphones placed in the vicinity of the loudspeaker to pick up sound waves emitted therefrom have been found to pick up too much ambient noise. The vibration transducer may be a contact microphone, which is an example of a piezoelectric microphone. Piezoelectric microphones include a thin-piezoelectric ceramic film and have been found to work in respect of the present invention, though other microphones such as laser microphones which also pick up vibrations could conceivably be used.

The audio output device suitable for use with the present invention may comprise at least one audio earpiece, which can include earphones, or alternatively the audio output device could support a personal area network, such as Bluetooth, or other remote connection means.

The amplifier for amplifying the signal from the microphone may be an audio amplifier. Such amplifiers suitable for the task are well known in the art and therefore do not require further discussion herein.

The apparatus may further include volume adjustment means. Although the device having the loudspeaker may include separate volume adjustment means, the amplifier may include these too to ensure that the sound from the device is not distorted and is clear.

The amplifier may further comprise a power output port. This power output port permits coupling of the apparatus of the present invention to the device having the loudspeaker so that the apparatus can power and/or charge the batteries of the device if present.

The amplifier of the present invention may be arranged to be provided power by an external device in the form of a power input socket connected to the amplifier, so that the device having the loudspeaker may be powered by an external power source, for example by the battery of a motorcycle.

The amplifier may also be provided with an alternative power source in the form of batteries in addition to or instead of the means to be powered by an external power source, such as the battery of a vehicle. The batteries may be chargeable from the external power source.

The amplifier may further include a VOX circuit so that it is only activated should an audible sound be emanating from the audio device. VOX circuits, or voice operated switches as they are otherwise known, are well known in the art and will not be further discussed herein. The VOX circuit will reduce power consumption by the audio amplification apparatus. Furthermore, a VOX circuit will also save on the power used by a powered headset that supports a personal area network, should this be the audio output device of choice.

The audio device may be a personal navigation device (PND), and the PND may be a satellite navigation device. However, although the present invention will mainly be discussed in the context of use with PNDs such as satellite navigation devices, it could of course be used in conjunction with any other device having a loudspeaker. In particular, the present invention is advantageous in situations where it is preferred that the device having a loudspeaker be listened to with headphones or similar, but where said device has no audio output port, or the port is broken. Other examples include devices such as radios or two-way radio transceivers, or even a device such as a baby monitor where it enables a user with a headset coupled to a remote or personal area network to hear the monitor whilst being out of earshot from it.

So that the apparatus of the present invention may be adhered to the loudspeaker of the device, the piezoelectric microphone may include an adhesive member for connection to the loudspeaker. This adhesive member may alternatively comprise a first hook and loop element for fixation to the loudspeaker and a second hook and loop element attachable to the vibration transducer, enabling removable attachment of said transducer. Of course, any alternative means to adhere the vibration transducer to the loudspeaker could be used.

The audio amplification apparatus may further comprise a casing, arranged to house the vibration transducer and the amplifier. The casing may be further arranged to accommodate the device having the loudspeaker. The casing may further comprise a transparent panel for viewing of a visual display on the device having the loudspeaker, if present. The casing may further include a padded insert, the padding being used so as to urge the device having the loudspeaker against the transparent panel, so that it is easier to see the visual display. The padding may be arranged to permit safe storage of the amplifier. The casing may be provided in a range of sizes to suit different makes of audio device. The casing may be weatherproof, particularly if the device is to be used on a motorcycle where the device may be open to the elements.

The audio amplification apparatus may further comprise a mount which is attachable to the device having the loudspeaker, the mount being arranged to removably support the vibration transducer in contact with the device having the loudspeaker. This mount may stay attached to the device having the loudspeaker, and permit the easy removal and application of the vibration transducer thereto. Advantageously, this will allow the device with the loudspeaker to be used for other purposes, without the audio amplification apparatus being attached. For example, if the device with a loudspeaker is a satellite navigation device, it could be used in a car without the audio amplification apparatus being attached. The satellite navigation device could then be transferred to a motorcycle where the audio amplification device could be attached by application of the transducer to the mount.

The mount may comprise a body having legs attached to side edges of the body, the legs having flanges arranged distally from the side edges for attachment of the mount to the device having the loudspeaker. The vibration transducer may fit snugly beneath the body and between the legs so that it is pressed against the surface of the device having the loudspeaker. The body may further comprise a tongue which is biased to push the vibration transducer onto the device having the loudspeaker.

There may also be provided a kit of parts comprising the audio amplification apparatus as previously described.

According to a second aspect of the present invention there is provided a method of amplifying an audible output of a device having a loudspeaker, the method comprising: attaching a vibration transducer to the device having the loudspeaker; generating an electrical signal representative at least in part of the audible output of the loudspeaker; amplifying the electrical signal; and communicating the amplified electrical signal to another loudspeaker that is separate from the loudspeaker of the device.

So that it may be better understood, at least one embodiment of the present invention will be now be described by way of example only, with reference to the following Figures:
**Figure 1** is a schematic rear view of the audio amplification apparatus of the present invention connected to a personal navigation device;
**Figure 2** is a schematic front view of the audio amplification apparatus of Figure 1;
**Figure 3** is a diagram of the present invention within a casing;
**Figure 4** is a schematic rear view of the audio amplification apparatus of the present invention connected to a personal navigation device further including a mount; and
**Figure 5** is a schematic front view of the mount of Figure 4.

With reference to all of the Figures, there is shown an audio amplification apparatus generally indicated 10 attached to a personal navigation device (PND) generally indicated 20. In this example the PND 20 is a satellite navigation device comprising a front panel 21 including a screen 22 for relaying visual instructions to a user, and a rear panel 23 including a loudspeaker 24 for relaying audible instructions to a user. The PND 20 further comprises a power input port 25 through which the PND 20 can be powered by an external power source (not shown).

The apparatus 10 comprises a vibration transducer, generally indicated 30 and in this example a contact microphone, and an amplifier, generally indicated 40. The apparatus 10 is connected to an audio output device, generally indicated 60, which comprises in this example an earpiece.

The amplifier 40 is an audio amplifier arranged to amplify a signal from the vibration transducer 30, which picks up vibrations originating from the loudspeaker 24 of the PND 20 and transmitting it via the earpiece 60 to a user. The components and structure of such audio amplifiers are well known in the art and therefore do not require further discussion herein.

The amplifier 40 is housed within a rigid plastic casing 41 having a front panel 42 and a rear panel 43, and side edges 44,45,46,47. Volume adjustment buttons 48a and 48b to raise and lower the volume are disposed on the front panel 42, though alternative volume adjustment means could instead be provided. Disposed on side edge 44 is a power input port 49 and a power output port 50. The power output port 50 permits coupling of the amplifier 40 to the PND 20 so that the apparatus 10 can power and/or charge the batteries of said PND 20, should they be present. In this example, the power output port 50 is a 5v dc miniUSB port, though alternatives could be used depending on the type of power input port 25 of the PND 20 for which the apparatus 10 is intended. The power input port 49 in this example is a 5v dc microUSB socket. The amplifier 40 may be powered by an external power source such as mains power or the battery of a vehicle, and be coupled to this device by a cable 51 having a suitable plug for connection to the external power source.

In an alternative example, the amplifier 40 may additionally be provided with batteries to power said amplifier 40 instead of, or in addition to, by an external power source. If provided, the batteries may be chargeable from the external power source.

Further disposed on side edge 44 of the amplifier is a 3.5mm audio output port 52 and on side edge 46 is a 3.5mm audio input port 53.

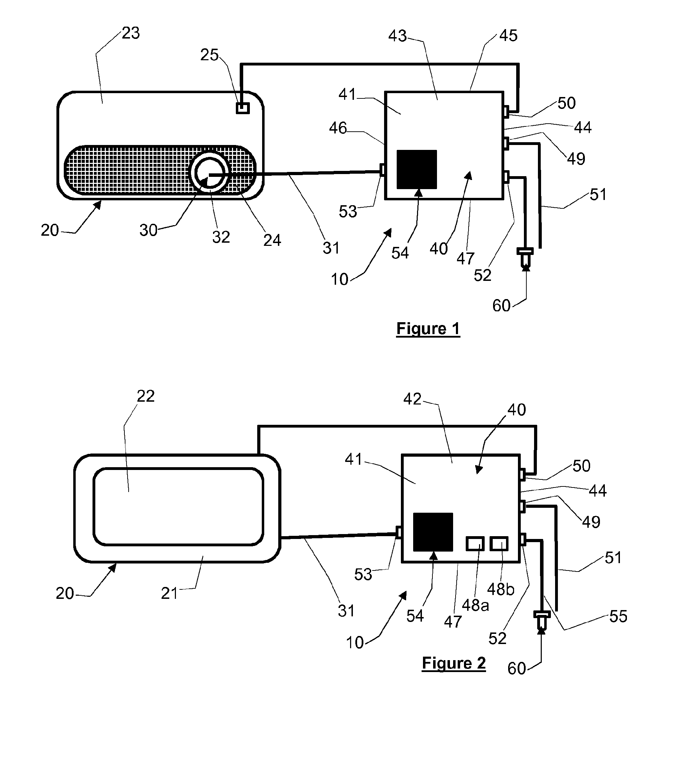

The amplifier 40 further includes a VOX circuit, generally indicated 54 in Figures 1 and 2, to activate the amplifier 40 only if an audible sound is detected from the personal navigation device 20. VOX circuits, or voice operated switches, are well known in the art and will not further be discussed herein.

The vibration transducer 30 is coupled to the amplifier 40 by a cable 31 which is plugged into the audio input port 53 of the amplifier 40, though the vibration transducer 30 may alternatively be hard-wired into the amplifier 40. In the present example the vibration transducer 30 is a piezoelectric microphone, and specifically a contact microphone as this is by far the most suitable type of transducer for use with the present invention, because alternative transducers such as dynamic microphones placed in the vicinity of the loudspeaker 24 to pick up sound waves emitted therefrom have been found to pick up too much ambient noise. The vibration transducer 30 has a generally circular planar surface 32 which is applied to the loudspeaker 24, and includes a thin-piezoelectric ceramic film (not shown) which picks up vibrations from the loudspeaker 24. In alternative embodiments, the vibration transducer could be a laser microphone or other suitable transducer. Although in this example the vibration transducer 30 is applied directly to the loudspeaker of the PND 20, it can be placed anywhere on the PND 20 where it can pick up the vibrations caused by an audible sound being emitted therefrom

The vibration transducer 30 is attached to the loudspeaker 22 of the personal navigation device 20 by way of an adhesive member (not shown) applied to the planar surface 32. The adhesive member comprises a double-sided adhesive tape. Alternatively, a first hook and loop element for fixation to the loudspeaker and a second hook and loop element attachable to the planar surface 32 of the vibration transducer 30, enabling removable attachment of said transducer 30, may be provided. Of course, any alternative means to adhere the vibration transducer 30 to the loudspeaker 24 is within the scope of the invention.

The earpiece 60 is provided to enable a user to hear the audible signals from the PND 20 which have been amplified by the amplifier 40. The earpiece 60 is connected the amplifier by a cable 55 plugged in the audio output port 52. The audio output device could alternatively comprise headphones, a speaker system incorporated within a motorcycle helmet or alternatively the audio output device could support a personal area network, such as Bluetooth, or other remote connection means, either plugged into the audio output port 52, or hardwired into the amplifier 40.

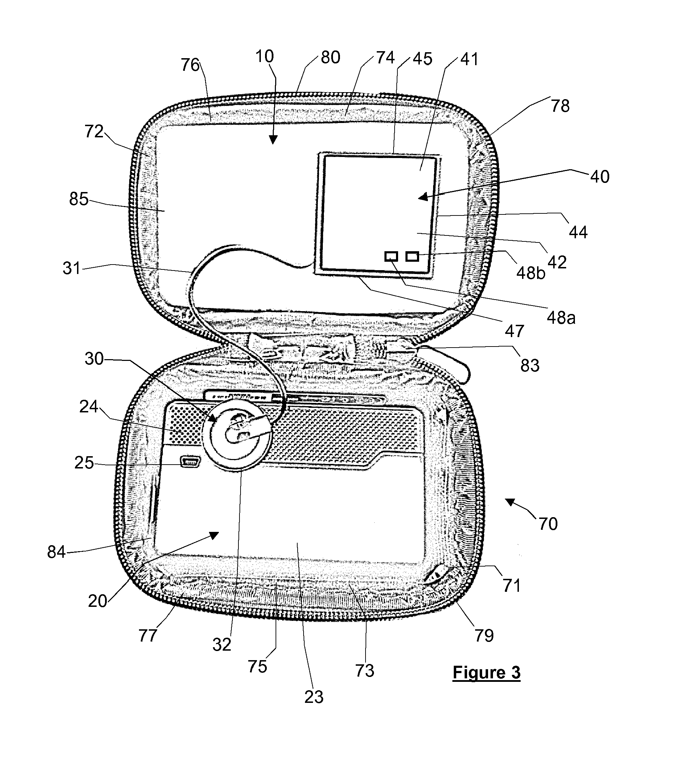

As shown in Figure 3, the audio amplification apparatus of the present invention further comprises a casing, generally indicated 70, which is arranged to house the vibration transducer 30, amplifier 40, and the PND 20. The casing 70 comprises a first part 71 and a second part 72. The first and second parts 71, 72 comprise respective substantially planar panels 73, 74 surrounded at the outer periphery 75, 76 thereof by side walls 77, 78 each having an upper lip, 79, 80. The first and second parts 71, 72 are joined by a hinge 81 arranged partially along the upper lips 79, 80 thereof and are arranged to move between an open position as shown in Figure 3 and a closed position whereby the first and second parts 71, 72 overlie in a clam shell arrangement so as to define a space 82 to contain the vibration transducer 30, amplifier 40 and the personal navigation device 20 therein. The upper lips 79, 80 of the first and second parts 71, 72 are provided with a separable slide fastener 83, such as a zipper to permit fastening of the first and second parts 71, 72 together. The first part 71 of the casing 70 includes a transparent panel (not shown) arranged for viewing of the screen 22 of the PND 20.

The first part 71 of the casing 70 further includes a first padded insert 84, the padded insert 84 being arranged to snugly secure the PND 20 in position and prevent it from moving within the casing 70. The first padded insert 84 is provided with an aperture (not shown) in which the PND 20 is secured. First padded inserts 84 can be provided whereby the shape and size of the aperture is chosen depending on the PND 20 to be held therein. Therefore, a single casing could be adapted for use with a range of different models of PND 20, or indeed other devices having a loudspeaker if they are to be provided within a casing.

The second part 72 of the casing is provided with a second padded insert 85, the second padded insert 85 being arranged to snugly secure the amplifier 40 in position and prevent it from moving. Furthermore, the second padded insert has a depth so that, when the first and second parts 71, 72 are arranged in the closed position, the second padded insert 85 urges the PND 20 against the transparent panel, so that it is easier for a user to see the screen 22 of the PND 20. The casing 70 is made from a weatherproof material, particularly as the PND 20 may be used on a motorcycle where the apparatus 10 will be open to the elements.

Whilst in this example the device having the loudspeaker is a PND 20, the apparatus described herein could of course be used on any other device having a loudspeaker. In particular, where it is preferred that the device having a loudspeaker be listened to with headphones or similar, but where said device has no audio output port, or the port is broken. Other examples include devices such as radios or two-way radio transceivers, or even a device such as a baby monitor where it enables a user with a headset coupled to a remote or personal area network to hear the monitor whilst being out of earshot from it.

The apparatus 10 of the present invention finds particular utility when used in situations where there are high levels of ambient noise, making it difficult or impossible to hear the audible sounds that are emitted from the loudspeaker of the device 20 (such as navigational instructions from a PND), and where the device 20 has no audio output port. The present invention allows for a user to listen to the device using an earpiece or similar, with amplification to overcome the ambient noise.

In use, a user will adhere the vibration transducer 30 to the loudspeaker or elsewhere on the body of the device 20 where vibrations caused by an audible sound emitted by the device 20 can be picked up by the vibration transducer 30. Sound waves and/or vibrations detected by the vibration transducer 30 are converted into an electrical signal which is communicated to the amplifier 40 via cable 31, which is plugged into the audio input port 53 of said amplifier 40. If the electrical signal is beyond a predetermined threshold, the VOX circuit 54 is triggered, which switches on the amplifier 40. The amplifier 40 then amplifies the electrical signal which is provided at the audio output port 52 to the earpiece 60 along cable 55. The earpiece 60 converts the electrical signal from the amplifier 40 into an audible sound which can clearly be heard by the user over the ambient noise.

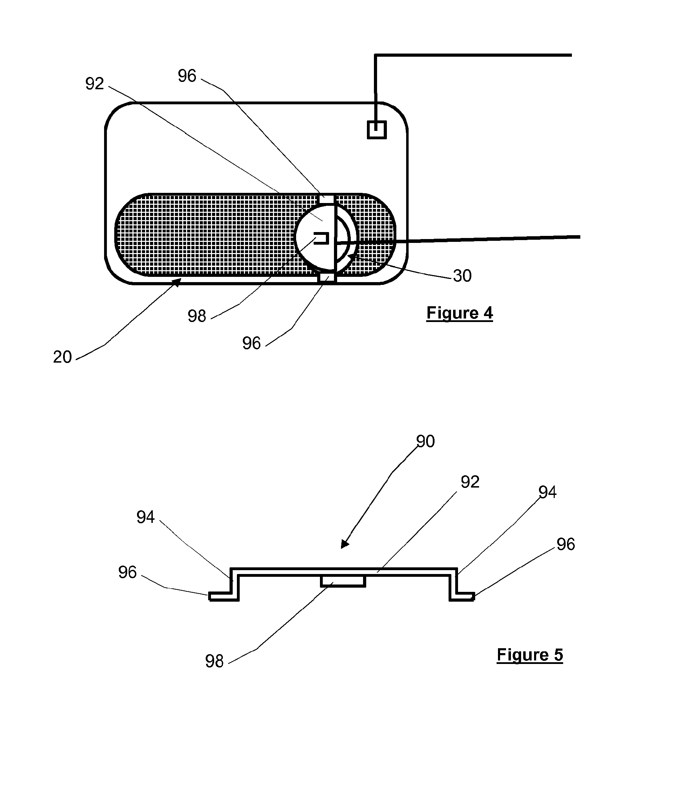

As shown in Figures 4 and 5, the audio amplification apparatus 10 may further comprise a mount, generally indicated 90, which is attachable to the PND 20, the mount 90 being arranged to removably support the vibration transducer 30 in contact with the PND 20. This permits the PND 20 to be used for other purposes, without the audio amplification apparatus 10 being attached. For example, if the PND 20 could be used in a car without the audio amplification apparatus 10 being attached. The PND 20 could then be transferred to a motorcycle where the audio amplification device 10 could be attached by application of the vibration transducer 30 to the mount 90.
The mount 90 comprises a body 92 having legs 94 attached to side edges of the body 92, the legs 94 having flanges 96 arranged distally from the side edges for attachment of the mount 90 to the PND 20. The vibration transducer 30 fits snugly beneath the body 92 and between the legs 94 so that it is pressed against the surface of the PND 20. The body 92 further comprises a tongue 98 which is biased to push the vibration transducer 30 onto the PND 20.

## Claims

1. An audio amplification apparatus (10) for attachment to a device having a loudspeaker (20), the apparatus comprising:
a vibration transducer (30) for attachment to the device having the loudspeaker (20);
an amplifier (40) coupled to the vibration transducer (30) for amplifying an electrical signal produced by the vibration transducer (30) representing at least in part an audible output of the loudspeaker (24) of the device (20), the vibration transducer picking up vibrations caused by sound emitted from the loudspeaker (24); and
an audio output port (52) operably coupled to the amplifier (40), thereby permitting connection to an audio output device (60).

2. An audio amplification apparatus (10) as claimed in Claim 1, wherein the vibration transducer (30) is a piezoelectric microphone.

3. An audio amplification apparatus (10) as claimed in Claim 1 or Claim 2, wherein the vibration transducer (30) is a contact microphone.

4. An audio amplification apparatus (10) as claimed in any of the preceding claims, wherein the audio output device (60) comprises at least one audio earpiece.

5. An audio amplification apparatus (10) as claimed in any of the preceding claims, wherein the audio output device (60) supports a personal area network.

6. An audio amplification apparatus (10) as claimed in any of the preceding claims, wherein the amplifier (40) is an audio amplifier.

7. An audio amplification apparatus (10) as claimed in any of the preceding claims, wherein the amplifier (40) further comprises a power output port (50).

8. An audio amplification apparatus (10) as claimed in any of the preceding claims, wherein the amplifier (40) includes a VOX circuit (54).

9. An audio amplification apparatus (10) as claimed in any of the preceding claims, wherein the vibration transducer (30) includes an adhesive member for connection to the loudspeaker (24).

10. An audio amplification apparatus (10) as claimed in any of the preceding claims, further comprising a casing (70), arranged to house the vibration transducer (30), the amplifier and the device having the loudspeaker (20).

11. An audio amplification apparatus (10) as claimed in Claim 10, wherein the casing (70) further comprises a transparent panel for viewing of a visual display (22) on the device having the loudspeaker (20).

12. An audio amplification apparatus (10) as claimed in Claims 10 or Claim 11, wherein the casing (70) is weatherproof.

13. An audio amplification apparatus (10) as claimed in any of the preceding claims, wherein the device having the loudspeaker (20) is a personal navigation device.

14. An audio amplification apparatus (10) as claimed in any of the preceding claims, further comprising a mount (90) which is attachable to the device having the loudspeaker (20), the mount (90) being arranged to support the vibration transducer (30) in contact with the device having the loudspeaker (20).

15. A method of amplifying an audible output of a device having a loudspeaker (20), the method comprising:
attaching a vibration transducer (30) to the device having the loudspeaker (20);
generating an electrical signal representative at least in part of the audible output of the loudspeaker (24) of the device (20);
amplifying the electrical signal; and
communicating the amplified electrical signal to another loudspeaker (60) that is separate from the loudspeaker (24) of the device (20).
